# EUROPÄISCHE PATENTANMELDUNG

(11) **EP 4 589 308 A1**
(43) Veröffentlichungstag der Anmeldung: **23.07.2025**
(21) Anmeldenummer: 24152068.3
(22) Anmeldetag: 16.01.2024
(51) Int. Cl.: G01R 1/20, H05K 1/16, G01R 1/04, G01R 1/067, G01R 27/14

(54) **MESSVORRICHTUNG ZUM MESSEN VON EINEM ELEKTRISCHEN WIDERSTAND**

(71) Anmelder: Physikalisch-Technische Bundesanstalt Braunschweig und Berlin, 38116 Braunschweig (DE)
(72) Erfinder: Kruskopf, Matthias, 31275 Lehrte (DE); Kieler, Oliver, 38465 Brome (DE)
(74) Vertreter: Gramm, Lins & Partner Patent- und Rechtsanwälte PartGmbB

(57) **Zusammenfassung**

Die vorliegende Erfindung betrifft eine Messvorrichtung (1) zum Messen von einem elektrischen Widerstand, wobei die Messvorrichtung (1) folgendes umfasst:
- eine erste Platine (10),
-wobei die erste Platine (10) eine Beschichtung (20) an einer ersten Platinenseite (11) der ersten Platine (10) und
-mindestens eine erste Kontaktfläche (41) und eine zweite Kontaktfläche (42) auf einer der ersten Platinenseite (11) gegenüberliegenden zweiten Platinenseite (12) der ersten Platine (10),
- wobei die erste Kontaktfläche (41) zu der zweiten Kontaktfläche (42) beabstandet ist;

- ein Substrat (30),
-wobei das Substrat (30) eine erste Substratseite aufweist, die der zweiten Platinenseite (12) zugewandt ist,
-wobei auf der ersten Substratseite eine dritte Kontaktfläche (43) und eine vierte Kontaktfläche (44) angeordnet sind,
- wobei die dritte Kontaktfläche (43) zu der vierten Kontaktfläche (44) beabstandet ist, wobei zwischen der dritten Kontaktfläche (43) und der vierten Kontaktfläche (44) ein Graphenwiderstand (5) auf der ersten Substratseite angeordnet ist,
- wobei der Graphenwiderstand (5) mit der dritten Kontaktfläche (43) und der vierten Kontaktfläche (44) elektrisch leitfähig verbunden ist und
- auf einer der ersten Platine (10) zugewandten Seite des Graphenwiderstands (5), der dritten Kontaktfläche (43) und der vierten Kontaktfläche (44) eine Dotierschicht (46) aufgebracht ist, sodass die Dotierschicht (46) den Graphenwiderstand (5) vollständig und die dritte Kontaktfläche (43) und die vierte Kontaktfläche (44) teilweise bedeckt und zu der zweiten Platinenseite (12) beabstandet ist;

- jeweils einen Au-Bump (50), der die erste Kontaktfläche (41) mit der vierten Kontaktfläche (44) und der die dritte Kontaktfläche (43) mit der zweiten Kontaktfläche (42) verbindet;
- eine diffusionsgeschlossene Einkapselung (60), die einen Raum zwischen der zweiten Platinenseite (12), der ersten Substratseite und den Au-Bumps (50) verschließt.

## Beschreibung

Die Erfindung betrifft eine Messvorrichtung zum Messen von einem elektrischen Widerstand.

Trotz der herausragenden Vorteile bei der Verwendung von Graphen als Quantenwiderstandsnormal in der Widerstandsmetrologie (höhere Messtemperatur, niedrigere Magnetfelder) war insbesondere die benötigte Langzeitstabilität der graphenbasierten Bauelemente im Vergleich zu den bisher verwendeten GaAsbasierten Bauelementen nicht ausreichend. Da die Langzeitstabilität der elektronischen Eigenschaften, insbesondere der Ladungsträgerdichte, ein Hauptkriterium für die allgemeine Eignung ist, entscheidet sich daran, ob sich Graphen mit seinen messtechnischen Vorteilen in der Widerstandsmetrologie durchsetzen kann.

Bisherige Ansätze konnten die Stabilität der elektronischen Eigenschaften verbessern, jedoch hatten hier bestimmte Umgebungseinflüsse, insbesondere die Gaszusammensetzung der Luft auf Zeitskalen von mehreren Wochen weiterhin einen deutlichen Effekt.

Bezüglich der Verbesserung der Langzeitstabilität gibt es bisher zwei Alternativen:
Durch das Auftragen von einem Polymerschichtsystem mit einer Dicke von ca. 500 nm (Lacke für die Elektronenstrahllithographie), welche zusätzlich mit einem Dotierstoff vermengt werden, können die Materialeigenschaften eingestellt werden. Die Kombination aus Polymereinkapselung und Dotierung stabilisiert die elektronischen Transporteigenschaften deutlich.

Alternativ ist bekannt, dass das graphenbasierte Bauelement mittels einer Glaskuppel geschützt und verklebt wird. Dadurch kann das graphenbasierte Bauelement von der Umgebungsluft abgeschirmt und die Langzeitstabilität deutlich verbessert werden. Bei diesem Verfahren wird das Bauelement diffusionsgeschlossen eingekapselt.

Diese Alternative benötigt weiterhin Drahtbonder zur Kontaktierung. Die Glaskuppel und Bonddrähte verhindern, dass Elektroden in unmittelbarer Nähe über dem Quantenwiderstand aufgebracht werden können.

Die Aufgabe der vorliegenden Erfindung ist es eine verbesserte Messvorrichtung zum Messen von einem elektrischen Widerstand bereitzustellen.

Die Aufgabe wird durch den unabhängigen Anspruch 1 gelöst. Die abhängigen Ansprüche geben vorteilhafte Ausführungsformen an.

Die Erfindung betrifft eine Messvorrichtung zum Messen von einem elektrischen Widerstand, wobei die Messvorrichtung folgendes umfasst:
- eine erste Platine,
   - wobei die erste Platine eine Beschichtung an einer ersten Platinenseite der ersten Platine und
   - mindestens eine erste Kontaktfläche und eine zweite Kontaktfläche auf einer der ersten Platinenseite gegenüberliegenden zweiten Platinenseite der ersten Platine,
   - wobei die erste Kontaktfläche zu der zweiten Kontaktfläche beabstandet ist;
- ein Substrat,
   - wobei das Substrat eine erste Substratseite aufweist, die der zweiten Platinenseite zugewandt ist,
   - wobei auf der ersten Substratseite eine dritte Kontaktfläche und eine vierte Kontaktfläche angeordnet sind,
      - wobei die dritte Kontaktfläche zu der vierten Kontaktfläche beabstandet ist, wobei zwischen der dritten Kontaktfläche und der vierten Kontaktfläche ein Graphenwiderstand auf der ersten Substratseite angeordnet ist,
      - wobei der Graphenwiderstand mit der dritten Kontaktfläche und der vierten Kontaktfläche elektrisch leitfähig verbunden ist und
      - auf einer der ersten Platine zugewandten Seite des Graphenwiderstands, der dritten Kontaktfläche und der vierten Kontaktfläche eine Dotierschicht aufgebracht ist, sodass die Dotierschicht den Graphenwiderstand vollständig und die dritte Kontaktfläche und die vierte Kontaktfläche teilweise bedeckt und zu der zweiten Platinenseite beabstandet ist;
- jeweils mindestens einen Au-Bump, der die erste Kontaktfläche mit der vierten Kontaktfläche und der die dritte Kontaktfläche mit der zweiten Kontaktfläche verbindet;
- eine diffusionsgeschlossene Einkapselung, die einen Raum zwischen der zweiten Platinenseite, der ersten Substratseite und den Au-Bumps verschließt.

Die Messvorrichtung weist eine erste Platine auf. Die erste Platine kann als ein Trägerelement ausgebildet sein. Insbesondere ist vorgesehen, dass die erste Platine nicht elektrisch leitfähig bzw. isoliert ist. Beispielsweise kann vorgesehen sein, dass die erste Platine aus einem Kunststoff gefertigt ist. Insbesondere kann vorgesehen sein, dass die erste Platine aus einem Material gefertigt ist, welches nicht ausgast. Die Beschichtungen der ersten Platinenseite der ersten Platine kann die erste Platinenseite teilweise oder vollständig bedecken. Insbesondere dient die Beschichtung zur Abschirmung des Graphenwiderstands. Vorgesehen sein kann, dass die Beschichtung teilweise oder vollständig aus Gold besteht. Insbesondere kann vorgesehen sein, dass die Beschichtung aus einem Material besteht, welches zur Abschirmung des Graphenwiderstands, insbesondere gegenüber HF Signalen, geeignet ist.

Die erste Kontaktfläche und die zweite Kontaktfläche können so ausgebildet sein, dass diese den korrespondierenden Au-Bump elektrisch leitfähig mit Messkontakten verbindet. Insbesondere kann die Kontaktfläche aus einem Material bestehen, welches dazu geeignet ist, mit dem Au-Bump durch Bonden sowohl eine elektrisch leitfähige als auch mechanische Verbindung einzugehen. Beispielsweise kann vorgesehen sein, dass die Kontaktfläche Gold aufweist oder aus Gold besteht. Ferner ist vorgesehen, dass die erste Kontaktfläche zur zweiten Kontaktfläche beabstandet ist. Dies bedeutet insbesondere, dass die erste Kontaktfläche mit der zweiten Kontaktfläche nicht elektrisch leitfähig ist bzw. die Kontaktflächen zueinander isoliert sind. Beabstandet bedeutet insbesondere, dass die erste Kontaktfläche und die zweite Kontaktfläche entlang der ersten Platinenseite zueinander beabstandet sind.

Weiter weist die Messvorrichtung ein Substrat auf. Bei dem Substrat handelt es sich um ein weiteres Trägerelement. Das Substrat ist so angeordnet, dass die zweite Platinenseite der ersten Substratseite zugewandt angeordnet ist. Insbesondere ist vorgesehen, dass die zweite Platinenseite parallel zur ersten Substratseite angeordnet ist. Ferner ist vorgesehen, dass die erste Substratseite zur zweiten Platinenseite beabstandet ist.

Weiter ist vorgesehen, dass die erste Substratseite eine dritte Kontaktfläche und eine vierte Kontaktfläche aufweist. Dabei ist vorgesehen, dass die dritte Kontaktfläche bzw. vierte Kontaktfläche so angeordnet ist, dass diese mittels eines Au-Bumps mit der korrespondieren Kontaktfläche der zweiten Platinenseite verbunden werden kann.

Ferner ist vorgesehen, dass zwischen der dritten Kontaktfläche und der vierten Kontaktfläche der Graphenwiderstand angeordnet ist. Insbesondere ist vorgesehen, dass die dritte Kontaktfläche und die vierte Kontaktfläche elektrisch leitfähig mit dem Graphenwiderstand verbunden ist. Ferner ist dabei vorgesehen, dass die dritte Kontaktfläche und die vierte Kontaktfläche entlang der zweiten Substratseite zueinander beabstandet sind. Mit anderen Worten ist vorgesehen, dass der Graphenwiderstand zwischen der dritten Kontaktfläche und der vierten Kontaktfläche auf der ersten Substratseite angeordnet ist. Zur Verbesserung der elektrischen Leitfähigkeit kann vorgesehen sein, dass jeweils die dritte Kontaktfläche und die vierte Kontaktfläche teilweise mit dem Graphenwiderstand überlappt.

Ferner ist vorgesehen, dass auf einer dem Substrat abgewandten Seite des Graphenwiderstands eine Dotierschicht aufgebracht ist. Weiter ist vorgesehen, dass die Dotierschicht zur zweiten Platinenseite beabstandet ist. Weiter kann vorgesehen sein, dass die Dotierschicht den Graphenwiderstand zumindesten teilweise auf der von dem Substrat abgewandten Seite bedeckt. Vorzugsweise ist vorgesehen, dass die Dotierschicht den Graphenwiderstand auf der dem Substrat abgewandten Seite vollständig bedeckt. Weiter kann vorzugsweise vorgesehen sein, dass die Dotierschicht den Graphenwiderstand vollständig bedeckt und die vierte Kontaktfläche teilweise bedeckt. Die Dotierschicht kann insbesondere so ausgebildet sein, dass eine Diffusion des Dotiertstoffs weg vom Quantenwiderstand minimiert wird. Beispielsweise kann vorgesehen sein, dass der Dotierstoff, welcher unter dem Handelsnamen F4-TCNQ erhältlich ist, verwendet wird.

Vorgesehen sein kann auch, dass die Messvorrichtung weitere Kontaktflächen aufweist. Insbesondere kann vorgesehen sein, dass die Messvorrichtung acht Messverbinder/Kontaktflächen aufweist. Dabei kann die Anzahl der Messverbinder /Kontaktflächen basierend auf der durchzuführenden Messung variieren.

Ferner ist vorgesehen, dass die Messvorrichtung eine diffusionsgeschlossene Einkapselung aufweist. Insbesondere ist die diffusionsgeschlossene Einkapselung so angeordnet, dass der Raum, welcher zwischen dem Substrat und der Platine gebildet wird, eingekesselt wird. Insbesondere kann die diffusionsgeschlossene Einkapselung den Raum zwischen dem Substrat und der ersten Platine begrenzen. Insbesondere ist vorgesehen, dass in dem Raum, welcher durch die diffusionsgeschlossene Einkapselung begrenzt wird, die Au-Bumbs, die dritte Kontaktfläche, die vierte Kontaktfläche, die Diffusionsbarriere und der Graphenwiderstand angeordnet ist. Damit ist vorgesehen, dass die erste Kontaktfläche und die zweite Kontaktfläche ein Kontaktieren des Graphenwiderstands mit externen Messvorrichtungen ermöglicht. Bevorzugt kann vorgesehen sein, dass die diffusionsgeschlossene Einkapselung zwischen der zweiten Platinenseite, der ersten Kontaktfläche und/oder der zweiten Kontaktfläche und dem Substrat ausgebildet ist. Mit anderen Worten verhindert die diffusionsgeschlossene Einkapselung ein Eindringen von Gasen in den Raum.

Vorgesehen sein kann, dass die erste Kontaktfläche mit der vierten Kontaktfläche und die dritte Kontaktfläche mit der zweiten Kontaktfläche mittels Flip-Chip-Bonden verbunden wird.

Die oben beschriebene Messvorrichtung hatte insbesondere den Vorteil, dass ein präzises Anordnen der jeweiligen Bauelemente vor dem Zusammenbringen des Substrats und der ersten Platine ermöglicht wird. Durch das Flip-Chip-Bonden mittels Au-Bumbs wird eine präzise Justierung des Substrats zu der ersten Platine ermöglicht. Insbesondere ermöglicht es das Flip-Chip-Bonden der Kontaktflächen mit einem vordefinierten Abstand. Die genaue Justierung der Bauelemente zueinander als auch die genaue Justierung des Substrats zur ersten Platinenseite ist wesentlich für die Reproduzierbarkeit einer solchen Messvorrichtung. Insbesondere ermöglicht eine solche Messvorrichtung eine verbesserte Messung des Graphenwiderstands um ein Graphenwiderstandsnormal zu realisieren.

Eine Ausführungsform sieht vor, dass die Messvorrichtung eine erste Elektrode und eine zweite Elektrode und eine dritte und eine vierte Elektrode aufweist, wobei die dritte und vierte Elektrode auf der zweiten Platinenseite zwischen der ersten und zweiten Kontaktfläche und zwischen den Au-Bumbs angeordnet und zueinander beabstandet sind.

Die dritte Elektrode und die vierte Elektrode kann so angeordnet sein, dass diese zu dem Graphenwiderstand, insbesondere zur Dotierschicht, beabstandet ist. Weiter sind die Elektroden dazu ausgebildet den Graphenwiderstand in deinen elektronischen Eigenschaften im Wechselstrombetrieb anzupassen. Dies kann beispielsweise erfolgen, indem zwischen der ersten Elektrode und/oder der zweiten Elektrode und der dritten Elektrode und/oder der vierten Elektrode ein vordefiniertes elektrisches Feld angeregt wird. Ferner kann vorgesehen sein, dass die Messvorrichtung weitere Elektroden aufweist die der zusätzlichen Schirmung gegen Elekromagnetische Signale.

Eine weitere Ausführungsform sieht vor, dass die erste und zweite Elektrode auf einer der ersten Substratseite gegenüberliegenden zweiten Substratseite angeordnet und zueinander beabstandet sind.

Dies hat den Vorteil, dass die Messvorrichtung kompakter gebaut werden kann und die erste und zweite Elektrode in einem vordefinierten Abstand zum Graphenwiderstand angeordnet ist.

Eine weitere Ausführungsform sieht vor, dass die erste und zweite Elektrode auf einer der zweiten Substratseite zugewandten ersten Seite einer zweiten Platine angeordnet und zueinander beabstandet sind, wobei die zweite Substratseite der ersten Substratseite gegenüberliegend angeordnet ist.

Vorgesehen sein kann, dass die Elektroden, insbesondere die erste und die zweite Elektrode, auf einer der zweiten Substratseite zugewandten ersten Seite der zweiten Platine angeordnet sind. Dies hat den Vorteil, dass die Elektroden zu dem Substrat beabstandet sind. Somit besteht eine verbesserte Isolation bezüglich der angelegten Spannung die Elektroden gegenüber dem Substrat, auf welchem der Graphenwiderstand aufgebracht ist. Ferner kann die zweite Platine auf der zweiten Seite zusätzlich eine weitere Beschichtung aufweisen. Diese Beschichtung hat auf der zweiten Platine den Zweck als Abschirmung gegen elektromagnetische Störsignale zu dienen und kann daher als Elektrode verstanden werden, die ebenfalls über ein Messystem kontaktiert wird.

Die Beschichtung auf der ersten Seite der ersten Platine kann ebenso eine Elektrode die sowohl der elektromagnetischen Abschirmung, als auch als Diffusionsbarriere gegen Gasmolekühle dient, umfassen.

Eine weitere Ausführungsform sieht vor, dass die diffusionsgeschlossene Einkapselung durch ein Epoxidharz gebildet ist.

Vorgesehen sein kann, dass die diffusionsgeschlossene Einkapselung durch ein Epoxidharz gebildet ist. Insbesondere kann vorgesehen sein, dass die diffusionsgeschlossene Einkapselung durch ein Epoxidharz, welches unter dem Handelsnamen EP21 TCHT-1 erhältlich ist, gebildet wird. Insbesondere kann vorgesehen sein, dass das Epoxidharz aus einem Material ist, welches dem mechanischen Stress der Goldkontakte in einem Temperaturanwendungsbereich zwischen 25 °C bis -270 °C minimiert. Mit anderen Worten kann vorgesehen sein, dass das Epoxidharz einen ähnlichen Ausdehnungskoeffizienten wie Gold aufweist.

Eine weitere Ausführungsform sieht vor, dass das Epoxidharz einen Temperaturkoeffizienten in der Größenordnung von 10 ppm/K hat.

Insbesondere kann vorgesehen sein, dass das Epoxidharz einen Temperaturkoeffizienten von 10 ppm/K, insbesondere einen Temperaturkoeffizienten zwischen 9 ppm/k und 11ppm/k aufweist.

Dies hat den Vorteil, dass der Temperaturkoeffizienten ungefähr dem Temperaturkoeffizienten von Gold entspricht, so dass mechanischer Stress zwischen den Kontaktflächen, welche aus Gold sein können, und dem Epoxidharz, welches zur Einkapselung das Raums unter anderem auf die Kontaktflächen aufgebracht werden kann, reduziert wird.

Eine weitere Ausführungsform sieht vor, dass das Substrat aus Siliziumkarbid und/oder die Kontaktflächen und/oder die Elektroden aus Gold sind.

Das Graphen kann direkt auf dem Siliziumkarbidsubstrat gewachsen und anschließend mittels Lithographie strukturiert und kontaktiert werden. Theoretisch kann man aber auch Graphen auf andere Substrate transferieren und zu Chips weiterverarbeiten.

Eine weitere Ausführungsform sieht vor, dass ein Isolationswiderstand zwischen der ersten Kontaktfläche und der ersten Platine, zwischen der zweiten Kontaktfläche und der ersten Platine, zwischen der dritten Kontaktfläche und dem Substrat und/oder zwischen der vierten Kontaktfläche und dem Substrat angeordnet ist, wobei der Isolationswiderstand ≥ 10¹⁴ Ohm beträgt.

Vorgesehen sein kann, dass die Kontaktflächen gegenüber dem jeweiligen Trägermaterial, also dem Substrat und oder der ersten Platine, elektrisch isoliert sind. Dies hat den Vorteil, dass die Messgenauigkeit verbessert wird. Mit anderen Worten weisen die Materialien des Substrats, der Platinen und der Diffusionsbarriere einen ausreichend hohen Isolationswiderstand auf. Vorgesehen sein kann, dass die Materialen so ausgesucht werden, dass diese Eigenschaft von allen Komponenten erfüllt werden.

Dies hat den Vorteil, dass die jeweiligen Bauelemente zueinander isoliert sind, sodass eine besonders präzise Messung des Graphenwiderstands erfolgen kann.

Eine weitere Ausführungsform sieht vor, dass die erste Kontaktfläche mit der vierten Kontaktfläche und die zweite Kontaktfläche mit der dritten Kontaktfläche mittels Au-Bumps durch Flip-Chip-Bonden verbunden ist.

Das Verbinden der Kontaktflächen mittels Flip-Chip-Bonden hat insbesondere den Vorteil, dass eine präzise Positionierung der Kontakte unter Berücksichtigung der vordefinierten Abstände, insbesondere des Abstands des Graphenwiderstands zur ersten Platine, erfolgen kann.

Eine weitere Ausführungsform sieht vor, dass die Messvorrichtung ferner einen ersten elektrischen Kontakt und einen zweiten elektrischen Kontakt aufweist, die außerhalb des durch die Einkapselung abgeschlossenen Raums angeordnet sind und wobei der erste elektrische Kontakt leitend mit der ersten Kontaktfläche und wobei der zweite elektrische Kontakt leitend mit der zweiten Kontaktfläche verbunden ist.

Ferner kann vorgesehen sein, dass die Kontaktflächen jeweils mit einem Kontakt, welche auch Messverbinder genannt werden kann, verbunden sind. Weiter kann auch vorgesehen sein, dass die Elektroden mit einem Kontakt verbunden sind. Insbesondere kann vorgesehen sein, dass der Kontakt so ausgebildet ist, dass dieser eine Anschlussleitung aufnehmen kann. Vorzugsweise kann vorgesehen sein, dass der Kontakt eine Buchse zum Aufnehmen der Anschlussleitung aufweist. Ferner können die Kontakte so angeordnet sein, dass diese zumindest mit der ersten Platine und der zweiten Platine auch mechanisch verbunden sind, sodass die Kontakte die erste Platine und die zweite Platine relativ zueinander in einem vordefinierten Abstand halten. Mit anderen Worten können die Kontakte sowohl eine elektrische Verbindung zu jeweils einer der Kontaktflächen oder einem der Kontakte herstellen und/oder zusätzlich eine mechanische Verbindung zu der ersten Platine und der zweiten Platine aufweisen. Insbesondere kann vorgesehen sein, dass jede Kontaktfläche und/oder jeder Elektrode mit einem separaten Kontakt verbunden ist. Dies hat den Vorteil, dass eine zuverlässige und einfach zu handhabende elektrische Kontaktierung der Messvorrichtung ermöglicht wird.

Eine weitere Ausführungsform sieht vor, dass ferner ein dritter elektrischer Kontakt mit der ersten Elektrode sowie ferner ein vierter elektrischer Kontakt mit der zweiten Elektrode leitfähig verbunden sind.

Dies hat den Vorteil, dass eine einfache Verbindung zu den Elektroden ermöglicht wird.

Eine weitere Ausführungsform sieht vor, dass die zweite Platine einen vordefinierten Abstand zur ersten Platine hat.

Insbesondere kann vorgesehen sein, dass die erste Platine und die zweite Platine in einem vordefinierten Abstand relativ zueinander angeordnet sind. Entsprechend kann auch vorgesehen sein, dass die erste Platine und die zweite Platine ebenfalls in einem vordefinierten Abstand zu dem Substrat, insbesondere zu den Graphenwiderstand, angeordnet sind. Dies hat den Vorteil, dass eine reproduzierbare Ansteuerung der Elektroden, welche auf den jeweiligen Platinen angeordnet sind, zur Isolation des Graphenwiderstands erfolgen kann.

Eine weitere Ausführungsform sieht vor, dass die erste Kontaktfläche und die zweite Kontaktfläche mit dem Graphenwiderstand teilweise überlappen und der überlappende Teil der jeweiligen Kontaktfläche zwischen dem Graphenwiderstand und der Dotierschicht angeordnet ist.

Vorgesehen sein kann, dass Kontaktflächen ein Teil des Graphenwiderstandes sein können. Insbesondere kann vorgesehen sein, dass ein lithographischer Metallkontakt nur das Graphen berührt bzw mit diesem leicht überlappt damit ein elektrischer Kontakt mit dem Graphen zustande kommt.

Eine weitere Ausführungsform sieht vor, dass die zweite Platinenseite der ersten Platine zur ersten Substratseite einen Abstand von ca. 10 µm aufweist.

Ein geringer und homogener Abstand zwischen Platine und Graphenwiderstand kann hilfreich sein im Falle der Ausführungsform mit den zweigeteilten Elektroden für die Manipulation der Widerstandseigenschaften im Wechselstrombetrieb. Der Geringe Abstand erlaubt im Vergleich zu vorherigen Bauformen, dass nur geringe Spannungen an die Elektroden erforderlich sind. Solche geringen Abstände sind ohne Flip Chip Technik nicht möglich da Bonddrähte sonst stören.

Eine weitere Ausführungsform sieht vor, dass die erste, zweite, dritte und/oder vierte Elektrode eine Möglichkeit zum Anlegen einer elektrischen Spannung aufweisen.

Durch Anlegen einer elektrischen Spannung kann zwischen den Elektroden ein vordefiniertes elektrisches Feld eingestellt werden. Durch dieses vordefinierte elektrische Feld können insbesondere die Frequenzabhängigkeit des Graphenwiderstandes im Wechselstrombetrieb minimiert werden.

Die Erfindung wird anhand der beigefügten Figuren beispielhaft näher erläutert. Es zeigen:
- Figur 1: eine schematische Darstellung einer Messvorrichtung mit einem Substrat und einer ersten Platine;
- Figur 2: eine schematische Darstellung einer Messvorrichtung mit einem Substrat, einer ersten Platine und Elektroden; und
- Figur 3: eine schematische Darstellung einer Messvorrichtung mit einem Substrat, einer ersten Platine, einer zweiten Platine und Elektroden.

Bei dem im Folgenden erläuterten Ausführungsbeispiel handelt es sich um eine bevorzugte Ausführungsform der Erfindung. Bei dem Ausführungsbeispiel stellen die beschriebenen Komponenten der Ausführungsform jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren ist die beschriebene Ausführungsform auch durch weitere der bereits beschriebenen Merkmale der Erfindung ergänzbar.

In den Figuren bezeichnen gleiche Bezugszeichen jeweils funktionsgleiche Elemente.

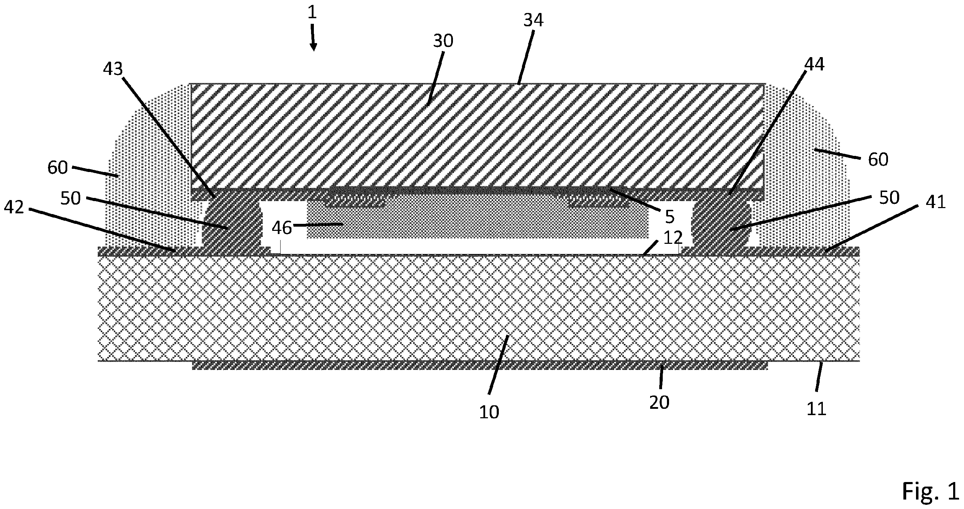

Figur 1 zeigt eine schematische Darstellung einer Messvorrichtung 1 mit einem Substrat 30 und einer ersten Platine 10. Die erste Platine 10 ist so angeordnet, dass eine zweite Platinenseite 12 einer ersten Substratseite zugewandt ist. Insbesondere ist die zweite Platinenseite 12 parallel zur ersten Substratseite angeordnet. Weiter weist die erste Platine 10 eine erste Platinenseite 11 auf. Auf der ersten Platinenseite 11 ist eine Beschichtung 20 angeordnet. Die Beschichtung 20 kann auch als Schirmelektrode bezeichnet werden, da diese eine Abschirmung gegen elektromagnetische Störsignale darstellt. Zusätzlich kann diese Elektrode helfen um sicherzustellen, dass keine Diffusion von Gasmolekülen durch die Platine erfolgen kann. Die Beschichtung 20 kann vollständig oder teilweise auf der ersten Platinenseite 11 aufgebracht sein, sollte jedoch mindestens den Bereich des Hohlraumes abdecken. Vorgesehen sein kann, dass die Beschichtung aus Gold ist. Auf der zweiten Platinenseite 12 ist zumindest eine erste Kontaktfläche 41 und eine zweite Kontaktfläche 42 aufgebracht. Vorgesehen sein kann, dass diese Kontaktflächen aus Gold sind. Insbesondere ist vorgesehen, dass die erste Kontaktfläche 41 und die zweite Kontaktfläche 42 zueinander beabstandet sind. Vorgesehen sein kann, dass auf der zweiten Platinenseite 12 weitere Kontaktflächen (hier nicht gezeigt) angeordnet sind. Insbesondere zeigt Figur 1 lediglich einen Querschnitt der Messvorrichtung, sodass die Messvorrichtung selbst nicht auf die hier gezeigten Bauelemente beschränkt ist.

Ferner weist die Messvorrichtung das Substrat 30 auf. Auf der ersten Substratseite ist eine dritte Kontaktfläche 43 und eine vierte Kontaktfläche 44 angeordnet. Insbesondere ist die dritte Kontaktfläche 43 so angeordnet, dass diese mittels mindestens einem Au-Bump 50 mit der zweiten Kontaktfläche 42 elektrisch leitfähig verbunden werden kann. Mit anderen Worten ist die dritte Kontaktfläche 43 relativ zu der zweiten Kontaktfläche 42 so angeordnet, dass diese sich entlang der ersten Substratseite bzw. der zweiten Platinenseite 12 zumindest teilweise überlappen. Insbesondere ist die vierte Kontaktfläche 44 so angeordnet, dass diese mittels mindestens einem Au-Bump 50 mit der ersten Kontaktfläche 41 elektrisch leitfähig verbunden werden kann. Mit anderen Worten ist die vierte Kontaktfläche 44 relativ zu der ersten Kontaktfläche 41 so angeordnet, dass diese sich entlang der ersten Substratseite bzw. der zweiten Platinenseite 12 zumindest teilweise überlappen. Weiter ist vorgesehen, dass zwischen der dritten Kontaktfläche 43 und der vierten Kontaktfläche 44 auf der ersten Substratseite ein Graphenwiderstand 5 angeordnet ist. Der Graphenwiderstand 5 ist elektrisch leitfähig sowohl mit der dritten Kontaktfläche 43 als auch mit der vierten Kontaktfläche 44 verbunden. Darüber hinaus ist die erste Kontaktfläche 41 ebenfalls elektrisch leitfähig mittels dem Au-Bump 50 und der vierten Kontaktfläche 44 mit dem Graphenwiderstand 5 verbunden. Auch die zweite Kontaktfläche 42 ist mittels einem Au-Bump 50 und der dritten Kontaktfläche 43 elektrisch leitfähig mit dem Graphenwiderstand verbunden. Vorgesehen sein kann, dass sowohl die dritte Kontaktfläche 43 als auch die vierte Kontaktfläche 44 zumindest teilweise mit dem Graphenwiderstand 5 überlappen, sodass der Graphenwiderstand 5 kontaktiert wird und einen geringen Kontaktwiderstand zur dritten Kontaktfläche 43 bzw. vierten Kontaktfläche 44 besitzt.

Ferner ist vorgesehen, dass auf einer Seite des Graphenwiderstands, welche von dem Substrat abgewandt ist und der ersten Platine 12 zugewandt ist, eine Dotierschicht 46 aufgebracht ist. Vorgesehen ist, dass die Dotierschicht 46 den Graphenwiderstand 5 vollständig bedeckt. Insbesondere kann vorgesehen sein, dass die Dotierschicht 46 zumindest teilweise auch die dritte Kontaktfläche 43 und die vierte Kontaktfläche 44 bedeckt.

Weiter kann vorgesehen sein, dass die dritte Kontaktfläche 43, der Graphenwiderstand 5 und/oder die vierte Kontaktfläche 44 gegenüber dem Substrat mittels einer Isolationsschicht zusätzlich isoliert sind.

Gegebenenfalls kann vorgesehen sein, dass auch die zweite Kontaktfläche 42 und die erste Kontaktfläche 41 mittels einer weiteren Isolationsschicht gegenüber der ersten Platine 10 isoliert sind.

Insbesondere kann vorgesehen sein, dass die erste Substratseite in einem vordefinierten Abstand zur zweiten Platinenseite 12 angeordnet ist. Der vordefinierte Abstand kann durch die Au-Bumps 50 einstellbar sein.

Weiter ist vorgesehen, dass ein Raum zwischen der ersten Substratseite und der zweiten Platinenseite 12, welcher seitlich durch die Au-Bumbs 50 begrenzt wird, mittels einer Einkapselung diffusionsdicht abgeschlossen ist. Mit anderen Worten kann vorgesehen sein, dass die Au-Bumps 50, die dritte Kontaktfläche 43, die vierte Kontaktfläche 44, der Graphenwiderstand 5 und die Dotierschicht 46 innerhalb des Raums angeordnet sind. Mit anderen Worten sind die Au-Bumps 50, die dritte Kontaktfläche 43, die vierte Kontaktfläche 44, der Graphenwiderstand 5 und die Dotierschicht 46 durch die Einkapselung 60, dem Substrat 30 und der ersten Platine 10 eingeschlossen. Eingeschlossen bedeutet, dass eine Diffusion von Gasen in den Raum reduziert bzw. verhindert wird.

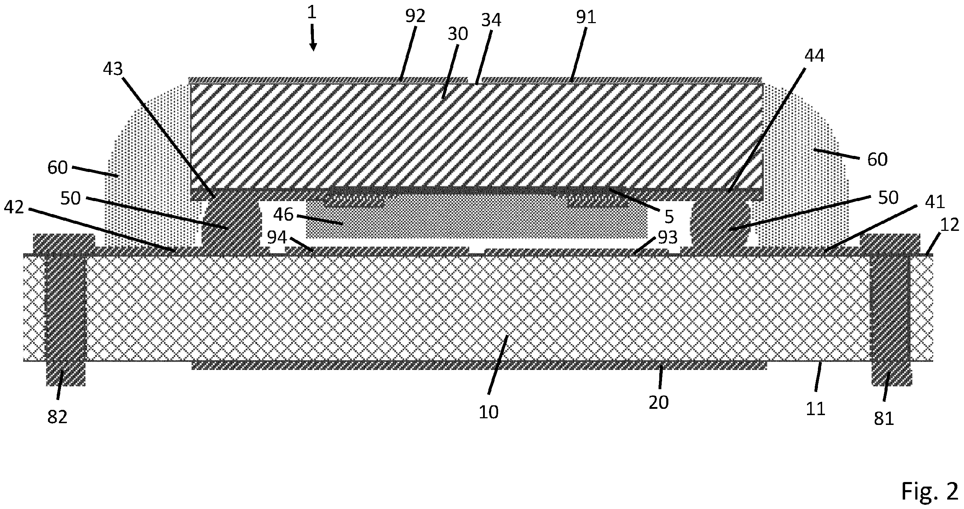

Figur 2 zeigt eine schematische Darstellung der Messvorrichtung 1 mit einem Substrat 30, der ersten Platine 12 und der Elektroden 91, 92, 93, 94.

Über das in Figur 1 gezeigt Ausführungsbeispiel hinaus zeigt Figur 2, dass auf einer zweiten Substratseite 34 eine erste Elektrode 91 und eine zweite Elektrode 92 angeordnet ist, wobei die erste Elektrode 91 von der zweiten Elektrode 92 beabstandet ist. Weiter kann vorgesehen sein, dass zwischen der ersten Kontaktfläche 41 und der zweiten Kontaktfläche 42 auf der zweiten Platinenseite 12 eine dritte Elektrode 93 und eine vierte Elektrode 94 angeordnet ist, wobei die Elektroden 93,94 zu den Kontaktflächen 41,42 beabstandet sind und die Elektroden 93 und 94 ebenfalls zueinander beabstandet sind. Eine entsprechende Kontaktierung der Elektroden 91,92, 93,94 ist hier nicht gezeigt. Vorgesehen sein kann jedoch, dass zwischen der zweiten Elektrode 92 und der vierte Elektrode 94 und der ersten Elektrode 91 und der dritten Elektrode 93 eine Spannung angelegt werden kann. Durch die angelegte Spannung kann ein elektrisches Feld zwischen den Elektroden (91, 92, 93, 94) und dem Graphenwiderstand (5) erzeugt werden.

Weiter ist vorgesehen, dass die Kontaktfläche 42 mit einem zweiten Kontakt 82 verbunden ist. Somit ist der zweite Kontakt 82 mittels dem Au-Bump 50 und der dritten Kontaktfläche 43 mit dem Graphenwiderstand 5 verbunden. Auch der erste Kontakt 81 ist elektrisch leitfähig mit der ersten Kontaktfläche 41 mittels dem Au-Bump 50 und der vierten Kontaktfläche 44 mit dem Graphenwiderstand 5 verbunden.

Der erste Kontakt 81 und der zweite Kontakt 82 können so ausgebildet sein, dass die Kontakte 81,82 Leitungen (hier nicht gezeigt) aufnehmen können.

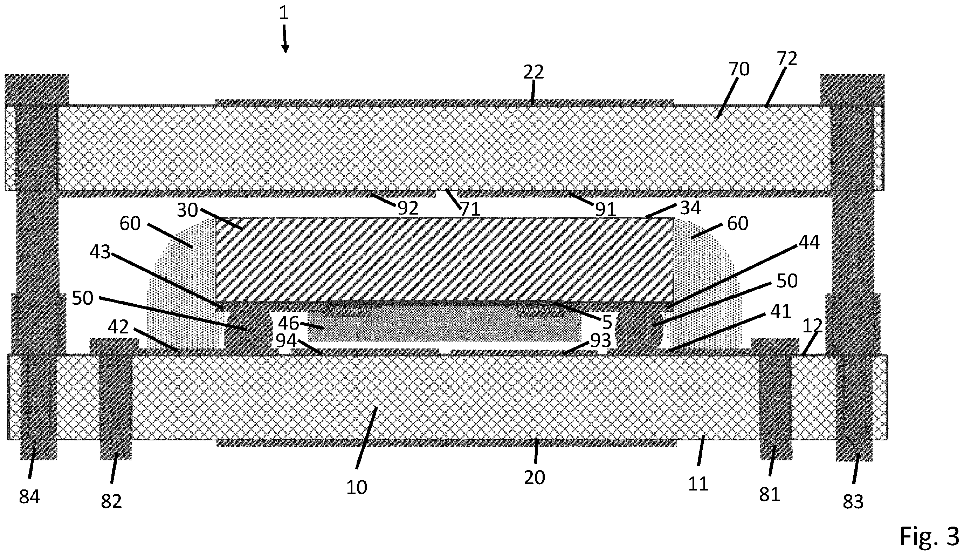

In Figur 3 ist eine schematische Darstellung der Messvorrichtung 1 mit dem Substrat 30, der ersten Platine 10, einer zweiten Platine 70 und der Elektroden 91, 92, 93, 94 gezeigt.

Vorgesehen sein kann, dass zusätzlich zu dem in Figur 1 oder Figur 2 gezeigten Ausführungsbeispiel eine zweite Platine 70 vorgesehen ist. Dabei kann vorgesehen sein, dass die zweite Platine 70 einer zweiten Substratseite 34 gegenüberliegend angeordnet ist. Vorzugsweise kann vorgesehen sein, dass eine erste Seite der zweiten Platine 71 der zweiten Substratseite 34 zugewandt und zu dieser parallel angeordnet ist. Wenn für den Wechselstrombetrieb, wie in Figur 2 gezeigt, Elektroden 91, 92, 93, 94 vorgesehen sein können, ist in diesem Ausführungsbeispiel vorgesehen, dass die erste Elektrode 91 und die zweite Elektrode 92 auf der ersten Seite der zweiten Platine 71 angeordnet sind. Dabei ist vorgesehen, dass die erste Elektrode 91 zur zweiten Elektrode 92 beabstandet angeordnet ist.

Ferner kann vorgesehen sein, dass die zweite Platine 70 mittels einem dritten Kontakt 83 und einen vierten Kontakt 84 relativ zu der ersten Platine 10 befestigt angeordnet ist. Vorgesehen sein kann, dass der dritte Kontakt 83 elektrisch leitfähig mit der ersten Elektrode 91 verbunden ist. Ferner kann der dritte Kontakt 83 zusätzlich dazu ausgebildet sein eine Leitung aufzunehmen. Ebenfalls kann die zweite Elektrode 92 mit dem vierten Kontakt 84 elektrisch leitfähig verbunden sein. Auch die vierte Kontaktfläche 44 kann ausgebildet sein eine Leitung zur elektrischen Kontaktierung aufzunehmen.

Darüber hinaus kann vorgesehen sein, dass die zweite Platine 70 auf einer zweiten Seite der zweiten Platine 72, welche der ersten Seite der zweiten Platine 71 gegenüberliegend angeordnet ist, eine zweite Beschichtung 22 aufweist. Vorgesehen sein kann, dass die zweite Beschichtung 22 vollständig oder teilweise auf der zweiten Seite der zweiten Platine 72 angeordnet ist. Vorgesehen sein kann, dass sowohl die Beschichtung 20 als auch die zweite Beschichtung 22 Gold aufweisen oder aus Gold bestehen. Die Beschichtung (22, 20) werden analog zu den anderen Elektroden elektrisch über Leitungen kontaktiert.

Die erfindungsgemäße Messvorrichtung umfasst einen graphenbasierten Quantenwiderstandsnormalen (Hall bar), eine Dotierschicht, eine Flip-Chip Verbindung zum Quantenwiderstandsnormal mittels Au-Bumps in Verbindung mit einer diffussionsgeschlossenen Einkapselung mittels z.B. Epoxidharz, Polyamid, Spin On Glas (SOG)und Diffusionsbarrieren sowie eine aktive und eine passive elektromagnetische Schirmung für den Wechselstrombetrieb. Die aktive Schirmung wird durch die zweigeteilten Elektroden realisiert an die Spannungen angelegt werden. Die passive Schirmung wird durch die Elektroden 22 und 20 realisiert (ohne anlegen einer Spannung). Um die Diffusion des Dotierstoffes innerhalb der Einkapselung vom Quantenwiderstand in das Epoxidharz hinein zu unterbinden, wird sichergestellt, dass die mit dem Dotierstoff vermengte Polymermatrix mit dem Epoxidharz nicht in direktem Kontakt steht. Um Diffusion aus der Umgebungsluft durch die erste Platine zu unterbinden, wird die erste Platine auf der ersten Seite stellenweise mit Gold beschichtet. Darüber hinaus kann die Beschichtung 20, 22 auch die passive Schirmung gegen elektromagnetische Störsignale darstellt.

Um eine Zuverlässigkeit der Kontakte zu erhöhen, kann vorgesehen sein, dass das Kontaktieren mit dem Flip Chip Bonder für jede Kontaktfläche zwei Au-Bumps platziert. Der Kontaktiervorgang kann bei 180°C mit einer Kraftrampe von 1 N/s stattfinden.

Zusätzlich kann die Messvorrichtung elektromagnetische Schirme integrieren, die für den Wechselstrombetrieb benötigt werden. Diese können im Vergleich zu bestehenden Ansätzen nun mit einer lateral deutlich höheren Genauigkeit und mit einem deutlich geringeren Abstand über dem Quantenwiderstand platziert werden.

Insgesamt zeigt das Beispiel, wie durch die Erfindung eine verbesserte Messvorrichtung zum Messen von einem elektrischen Widerstand im Gleichstrom-und Wechselstrombetrieb bereitgestellt werden kann.

### Bezugszeichenliste

- 1: Messvorrichtung
- 5: Graphenwiderstand
- 10: erste Platine
- 11: erste Platinenseite
- 12: zweite Platinenseite
- 20: Beschichtung
- 22: zweite Beschichtung
- 30: Substrat
- 34: zweite Substratseite
- 41: erste Kontaktfläche
- 42: zweite Kontaktfläche
- 43: dritte Kontaktfläche
- 44: vierte Kontaktfläche
- 46: Dotierschicht
- 50: Au-Bumb
- 60: Einkapselung
- 70: zweite Platine
- 71: erste Seite der zweiten Platine
- 72: zweite Seite der zweiten Platine
- 81: erster Messkontakt
- 82: zweiter Messkontakt
- 83: dritter Messkontakt
- 84: vierter Messkontakt
- 91: erste Elektrode
- 92: zweite Elektrode
- 93: dritte Elektrode
- 94: vierte Elektrode

## Patentansprüche

1. Messvorrichtung (1) zum Messen von einem elektrischen Widerstand, wobei die Messvorrichtung (1) folgendes umfasst:
- eine erste Platine (10),
- wobei die erste Platine (10) eine Beschichtung (20) an einer ersten Platinenseite (11) der ersten Platine (10) und
- mindestens eine erste Kontaktfläche (41) und eine zweite Kontaktfläche (42) auf einer der ersten Platinenseite (11) gegenüberliegenden zweiten Platinenseite (12) der ersten Platine (10),
- wobei die erste Kontaktfläche (41) zu der zweiten Kontaktfläche (42) beabstandet ist;
- ein Substrat (30),
- wobei das Substrat (30) eine erste Substratseite aufweist, die der zweiten Platinenseite (12) zugewandt ist,
- wobei auf der ersten Substratseite eine dritte Kontaktfläche (43) und eine vierte Kontaktfläche (44) angeordnet sind,
- wobei die dritte Kontaktfläche (43) zu der vierten Kontaktfläche (44) beabstandet ist, wobei zwischen der dritten Kontaktfläche (43) und der vierten Kontaktfläche (44) ein Graphenwiderstand (5) auf der ersten Substratseite angeordnet ist,
- wobei der Graphenwiderstand (5) mit der dritten Kontaktfläche (43) und der vierten Kontaktfläche (44) elektrisch leitfähig verbunden ist und
- auf einer der ersten Platine (10) zugewandten Seite des Graphenwiderstands (5), der dritten Kontaktfläche (43) und der vierten Kontaktfläche (44) eine Dotierschicht (46) aufgebracht ist, sodass die Dotierschicht (46) den Graphenwiderstand (5) vollständig und die dritte Kontaktfläche (43) und die vierte Kontaktfläche (44) teilweise bedeckt und zu der zweiten Platinenseite (12) beabstandet ist;
- jeweils mindestens einen Au-Bump (50), der die erste Kontaktfläche (41) mit der vierten Kontaktfläche (44) und der die dritte Kontaktfläche (43) mit der zweiten Kontaktfläche (42) verbindet;
- eine diffusionsgeschlossene Einkapselung (60), die einen Raum zwischen der zweiten Platinenseite (12), der ersten Substratseite und den Au-Bumps (50) verschließt.

2. Messvorrichtung (1) nach Anspruch 1, wobei die Messvorrichtung (1) eine erste Elektrode (91) und eine zweite Elektrode (92) und eine dritte und eine vierte Elektrode (93, 94) aufweist, wobei die dritte und vierte Elektrode (93, 94) auf der zweiten Platinenseite (12) zwischen der ersten und zweiten Kontaktfläche (41, 42) und zwischen den Au-Bumps (50) angeordnet und zueinander beabstandet sind.

3. Messvorrichtung (1) gemäß Anspruch 2, wobei die erste und zweite Elektrode (91, 92) auf einer der ersten Substratseite gegenüberliegenden zweiten Substratseite (34) angeordnet und zueinander beabstandet sind.

4. Messvorrichtung (1) gemäß Anspruch 2, wobei die erste und zweite Elektrode (91, 92) auf einer der zweiten Substratseite (34) zugewandten ersten Seite (71) einer zweiten Platine (70) angeordnet und zueinander beabstandet sind, wobei die zweite Substratseite (12) der ersten Substratseite (11) gegenüberliegend angeordnet ist.

5. Messvorrichtung (1) nach einem der vorherigen Ansprüche, wobei die diffusionsgeschlossene Einkapselung (60) durch ein Epoxidharz gebildet ist.

6. Messvorrichtung (1) nach Anspruch 5, wobei das Epoxidharz einen Temperaturkoeffizienten in der Größenordnung von 10 ppm/K hat.

7. Messvorrichtung (1) nach einem der vorherigen Ansprüche, wobei das Substrat (30) aus Siliziumkarbid und/oder die Kontaktflächen (41-44) und/oder die Elektroden (91-94) aus Gold sind.

8. Messvorrichtung (1) gemäß einem der vorherigen Ansprüche, wobei ein Isolationswiderstand zwischen der ersten Kontaktfläche (41) und der ersten Platine (10), zwischen der zweiten Kontaktfläche (42) und der ersten Platine (10), zwischen der dritten Kontaktfläche (43) und dem Substrat (30) und/oder zwischen der vierten Kontaktfläche (44) und dem Substrat (30) angeordnet ist, wobei der Isolationswiderstand ≥ 10¹⁴ Ohm beträgt.

9. Messvorrichtung (1) gemäß einem der vorherigen Ansprüche, wobei die erste Kontaktfläche (41) mit der vierten Kontaktfläche (44) und die zweite Kontaktfläche (42) mit der dritten Kontaktfläche (43) mittels Au-Bumps (50) durch Flip-Chip-Bonden verbunden ist.

10. Messvorrichtung (1) gemäß einem der vorherigen Ansprüche, wobei die Messvorrichtung (1) ferner einen ersten elektrischen Kontakt (81) und einen zweiten elektrischen Kontakt (82) aufweist, die außerhalb des durch die Einkapselung abgeschlossenen Raums angeordnet sind und wobei der erste elektrische Kontakt (81) leitend mit der ersten Kontaktfläche (41) und wobei der zweite elektrische Kontakt (82) leitend mit der zweiten Kontaktfläche (42) verbunden ist.

11. Messvorrichtung (1) gemäß einem der Ansprüche 2 bis 10, wobei ferner ein dritter elektrischer Kontakt (83) mit der ersten Elektrode (91) sowie ferner ein vierter elektrischer Kontakt (84) mit der zweiten Elektrode (92) leitfähig verbunden sind.

12. Messvorrichtung (1) gemäß Anspruch 11, wobei die zweite Platine (70) einen vordefinierten Abstand zur ersten Platine (10) hat.

13. Messvorrichtung (1) gemäß einem der vorherigen Ansprüche, wobei die erste Kontaktfläche (43) und die zweite Kontaktfläche (44) mit dem Graphenwiderstand (5) teilweise überlappen und der überlappende Teil der jeweiligen Kontaktfläche (43, 44) zwischen dem Graphenwiderstand (5) und der Dotierschicht (46) angeordnet ist.

14. Messvorrichtung (1) gemäß einem der vorherigen Ansprüche, wobei die zweite Platinenseite (12) zur ersten Substratseite einen Abstand von 5 µm bis 20 µm aufweist.

15. Messvorrichtung (1) gemäß einem der Ansprüche 2 bis 14, wobei die erste, zweite, dritte und/oder vierte Elektrode (91-94) eine Möglichkeit zum Anlegen einer elektrischen Spannung aufweisen.
